Europäisches Patentamt

European Patent Office

Office européen des brevets

(11) Publication number: **0 257 137**
A1

(12) **EUROPEAN PATENT APPLICATION**

(21) Application number: 86201429.7

(22) Date of filing: 15.08.86

(51) Int. Cl.⁴: **G01L 5/00** , G01M 19/00

(43) Date of publication of application:
02.03.88 Bulletin 88/09

(84) Designated Contracting States:
AT BE CH DE FR GB IT LI LU NL SE

(71) Applicant: ELMECON, CONSULTING
ASSOCIATES B.V.
Runstraat 15
NL-5504 RD Veldhoven(NL)

(72) Inventor: Piepers, Harry Christiaan
Jan Luykenstraat 44
NI-5615 JM Eindhoven(NL)

(74) Representative: Lips, Hendrik Jan George, Ir.
et al
HAAGSCH OCTROOIBUREAU Breitnerlaan
146
NL-2596 HG Den Haag(NL)

(54) Device for measuring and controlling the spring contents of a connector block.

(57) A device for measuring and controlling the spring contacts (2) of a connector block (3) comprising a number of measuring pins (1) each being positioned and biassed such that they can be simultaneously inserted into and withdrawn from a number of cavities of a connector block (3) and in or out the spring contacts (2), if any, present in these. When engaging a spring contact (2) the related measuring pin (1) will be displaced in a way depending on the forces exerted by the spring contact (2) on it. By measuring the displacement of the pin (1) said forces can be determined and by this wether the related connector block (3) satisfies the demands set to it.

FIG.1

## Device for measuring and controlling the spring contacts of a connector block

The invention relates to a device for measuring and controlling the spring contacts being located in a connector block, said device being provided with measuring pins which can be inserted into and can be withdrawn from the spring contacts to be controlled, means being present for measuring the force exerted by a spring contact on a measuring pin.

Such devices are of importance for the electronic industry as the purchasers of connector blocks demand an almost 100 % guarantee for the proper functioning of all spring contacts in the connector blocks. The non-functioning of one single spring contact in a connector block, such as applied in the telecommunication, aviation and space travel techniques may cause substantial disadvantages and may even have serious consequences.

In a known device for the above mentioned object use is made of strain gauges by which the normal force of the spring contacts is measured. A disadvantage of this device is that the measured values are subject to drift, thus making frequent calibration necessary. In addition with this device it is not possible to measure simultaneously spring contacts in a connector block, being placed in the usual way at a small distance from each other in two mutual perpendicular directions.

The object of the invention now is to eliminate these disadvantages and to that end the device comprises a number of measuring pins being positioned in such a way, that they can simultaneously be inserted into a number of adjacent cavities of a connector block and into the spring contacts which possibly are present in these and which pins can be withdrawn from said cavities simultaneously, each of said measuring pins being positioned and being biased individually such that it will be subjected to a certain displacement in the longitudinal direction on inserting it into and withdrawing it from a spring contact, said displacement being measured by means capable of providing signals which can be supplied to a control device determining whether the relevant connector block or the section of it which is controlled satisfies the demands set to it.

In this way a fully automated measuring device is obtained with a measuring speed which may be equal to the presently customary maximum production speed of the connector blocks. So the device may be positioned adjacent to the assembling/filling device by which the spring contacts are positioned into the cavities of the connector blocks, so that the connector blocks may be controlled immediately after being assembled. This also provides a direct control of the functioning of the assembling/filling device. For example, it can be checked immediately whether the absence of a contact in a specific cavity repeats itself in subsequent connector blocks or has occured by chance only once.

According to a further eleboration of the invention it may be provided, that for measuring the displacement of a measuring pin the latter is provided with a measuring van cooperating with a light-emitting or light-reflecting element and an electronic camera which are mounted in a fixed position in a plane perpendicular to the direction of movement of the measuring pin.

In particular the light-emitting element and the electronic camera will be present on either side of a measuring vane so that the electronic camera will register a projection of the measuring vane, which projection will change on movement of the measuring vane.

This provides a simple and reliable device though it might be possible as well to use a light-emitting element being present substantially at the position of the electronic camera, said elelctronic camera then measuring the amount of light being reflected directly by the measuring vane.

For a particularly accurate measuring of the displacement of the measuring pin it will be provided, that the measuring vane, seen in a plane perpendicular to the centre line of the meausring pin, has the shape of a triangle.

In order to avoid problems arising from a possible rotation of the measuring pin around its centre line, preferably the measuring vane substantially will have the shape of a cone.

When using the device the projection of the measuring vane, as observed by the electronic camera, will thus have a trapezoidal shape.

According to a further elaboration of the invention it will be provided that, when a number of spring contacts is present as well in the longitudinal as in the transversal direction of a connector block, the measuring vanes of a row of measuring pins being positioned in the measuring direction of the electronic camera, will be staggered in the longitudinal direction of the measuring pins.

Preferably it will be provided, that the control device is a programmable microprocessor by which the signals provided by the electronicc camera will be processed and compared with predetermined desired values for determining whether all spring contacts of a connector block are present and whether the inserting and withdrawing forces of all spring contacts are within the desired range of values.

To that end additional means may be present to adjust the assembling process of the controlled connector blocks.

The measurement data may be recorded on a control strip, which control strip may be delivered to the user with the relevant connector block.

The invention will now be illustrated by means of a description of a preferred embodiment, reference being made to the drawing, in which:

Fig. 1 shows diagrammatically a view of the device for elucidating its functioning;

Fig. 2 shows a side view and a partial cross-sectional view of the device of Fig. 1;

Fig. 3 shows a scheme of the electronic control unit with possibilities for the output of measurement data; and

Fig. 4 shows a chart representing the inserting and withdrawing forces exerted to a pin of the control unit being inserted into and withdrawn from a spring contact in a cavity of a connector block to be controlled.

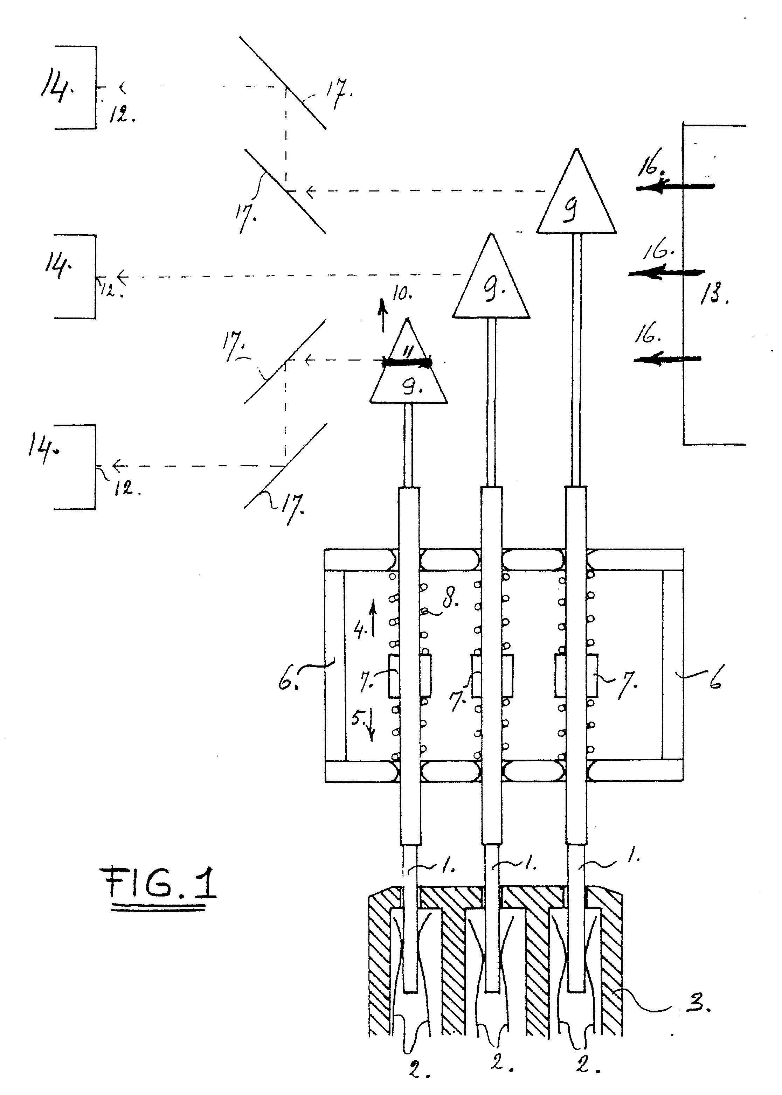

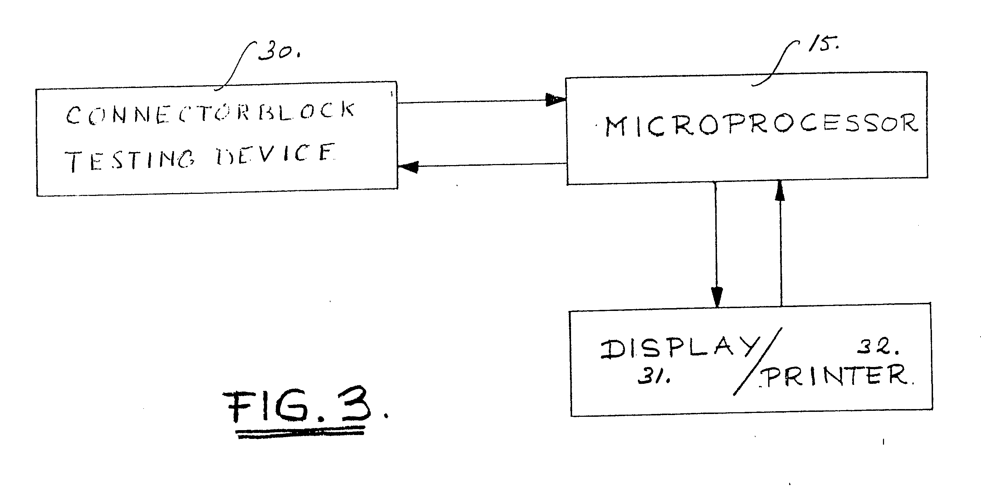

Fig. 1 diagrammatically shows the central section of the control device for measuring the forces exerted to pins 1 when inserting these into and withdrawing these from the spring contacts 2 in the connector block 3. The pins 1 are mounted in the fixedly positioned measuring block 6 such that they are biassed into two directions, indicated with the arrows 4 and 5. On inserting a pin 1 into the spring contact 2, the pin 1 moves in the direction 4 and the upper spring 8 is compressed by the block 7 connected to the pin. The rotational symmetrical body 9 forming the measuring vane is connected to the pin 1 and is displaced in the direction 10 together with the pin 1 so that the width 11 of the vane on the array 12 of the electronic camera 14 will be changed. By this the displacement of the measuring vane 9 and thus the inserting force of the pin 1 into the spring contact 2, can be calculated by the microprocessor 15 (see Fig. 3) of the control device.

The measuring vanes 9 at the ends of the pins 1 may be staggered. By means of mirrors or prisms the projections of the outermost measuring vanes may stagger so that these will fall on arrays 12 of separate electronic cameras 14.

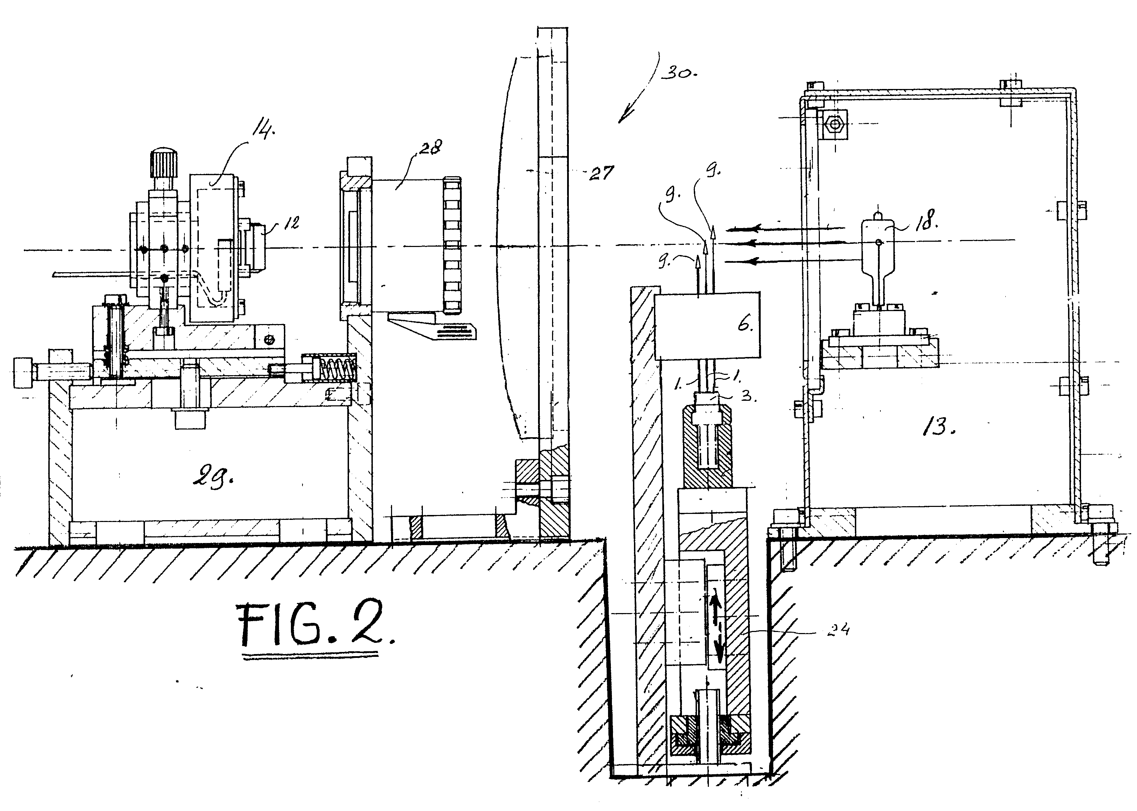

In Fig. 2 the control device is shown more in detail, various parts being indicated with the same reference numbers as are used in Fig. 1. In the device the lamp 18 in the lamp housing 13 will illuminate the measuring vanes 9. The projection of the measuring vanes, which will be trapezoidal in shape, is collimated by the lens 27 in the image objective 28 and is thus imaged on the electronic camera 14. By the lift mechanism 24, not further described in detail, the connector block 3 is either pressed onto or withdrawn from the measuring pins, by which the measuring vanes 9 will be subjected to a displacement.

Fig. 3 shows the scheme of the electronic control unit belonging to the control device 30 of Figs. 1 and 2. The control unit comprises the microprocessor 15 for receiving and processing the data provided by the electronic camera 14. Output of data from the microprocessor 15 may occur to a video-display 31 or to a printer 32.

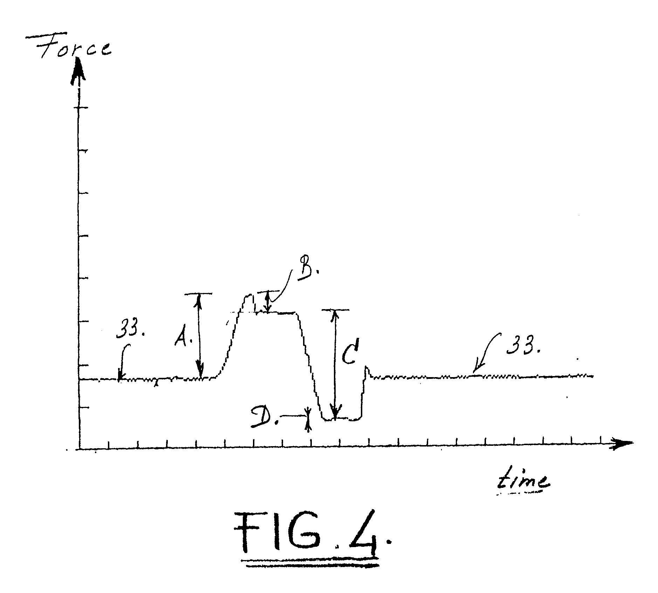

Fig. 4 shows a chart of the force that may be exerted on a pin 1 when inserting a pin 1 (see Fig. 1) into a spring contact 2 and when withdrawing the pin.

The measuring level without load, so when the pin is not engaging a spring contact, is indicated by 33. When inserting the pin into a spring contact the value measured will increase by a value A and will decrease immediately thereafter by a value B, the so-called "shoot-through effect". So the inserting force is represented by the value A-B. When withdrawing the pin from the spring contact the value measured will decrease by a value C and will "shoot-through" over a value D. So the withdrawing force is represented by the value C-D. After the pin has been completely withdrawn from the spring contact, the pin, will return to its original position and so to the unloaded measuring level 33.

It will be obvious that in the drawing only a preferred embodiment of the control device is represented which is described above and that many modifications may be made without departing from the inventive concept.

## Claims

1. A device for measuring and controlling the spring contacts being located in a connector block, said device being provided with measuring pins which can be inserted into and can be withdrawn from the spring contacts to be controlled, means being present for measuring the force exerted by a spring contact on a measuring pin, characterized in that the device comprises a number of measuring pins (1), being positioned in such a way, that they can be simultaneously inserted into a number of adjacent cavities of a connector block (3) and into the spring contacts (2) which possibly are present in these and which pins (1) can be withdrawn from said cavities simultaneously, each of said measuring pins (1) being positioned and being biassed individually such that it will be subjected to a certain displacement (A, B, C, D) in the longitudinal direction on inserting it into and withdrawing it from a spring contact (2), said displacement being measured by means (12,14) capable of providing signals which can be supplied to a control device (15) determining whether the relevant connector block (3) or the section of it which is controlled satisfies the demands set to it.

2. A device according to claim 1, characterized in that for measuring the displacement of a measuring pin (1) the latter is provided with a measuring vane (9) cooperating with a light-emitting or light-reflecting element (18) and an electronic camera (14), which are mounted in a fixed position in a plane perpendicular to the direction of movement of the measuring pin (1).

3. A device according to claim 2, characterized in that the light-emitting element (18) and the electronic camera (14) will be present on either side of a measuring vane (9) so that the electronic camera (14) will register a projection of the measuring vane (9), which projection will change on movement of the measuring vane (9).

4. A device according to one of the claims 2 - 3, characterized in that the measuring vane (9) seen in a plane perpendicular to the centre line of the measuring pin (1) has the shape of a triangle.

5. A device according to claim 4, characterized in that the measuring vane (9) substantially is having the shape of a cone.

6. A device according to one of the claims 2 - 5, characterized in that when a number of spring contacts (2) is present as well in the longitudinal as in the transversal direction of a connector block (3) the measuring vanes (9) of a row of measuring pins (1) being positioned in the measuring direction of the electronic camera (14) will be staggered in the longitudinal direction of the measuring pins (1).

7. A device according to one of the claims 2 - 6, characterized in that the control device is a programmable microprocessor (15) by which the signals provided by the electronic camera (14) will be processed and compared with pre-determined desired values for determining whether all spring contacts (2) of a connector block (3) are present and whether the inserting and withdrawing forces of all spring contacts (2) are within the desired range of values.

8. A device according to claim 7, characterized in that additional means are present to adjust the assembling process of the controlled connector blocks (3).

**FIG.1**

0 257 137

14.

12.

28.

30.

27.

9.

9.

9.

9.

18.

6.

1.

1.

3.

13.

29.

24.

# FIG. 2.

ELMECON, CONSULTING ASSOCIATES B.V., VELDHOVEN

0 257 137

┌─────────────────────────┐                    ┌─────────────────────────┐
│  ⌐30.                   │                    │  ⌐15.                   │
│ CONNECTOR BLOCK         │  ─────────────▶    │ MICROPROCESSOR          │
│ TESTING DEVICE          │                    │                         │
│                         │  ◀─────────────    │                         │
└─────────────────────────┘                    └─────────────────────────┘
                                                      │        ▲
                                                      ▼        │
                                               ┌─────────────────────────┐
                                               │ DISPLAY/        32.     │
                                               │   31.    /PRINTER.      │
                                               └─────────────────────────┘

FIG. 3.

FIG.4.

ELMECON, CONSULTING ASSOCIATES B.V., VELDHOVEN

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| Y | FR-A-2 516 238 (SOCAPEX)<br>* Claims 1,4; figures * | 1 | G 01 L 5/00<br>G 01 M 19/00 |
| Y | DE-B-2 344 544 (SIEMENS AG)<br>* Column 6, lines 3-28; figures 3-5 * | 1 | |
| Y | US-A-3 808 874 (T. TREVITHICK)<br>* Column 4, lines 52-68; column 5, lines 1-18; figures * | 1 | |
| A | FR-A-2 339 838 (RCA CORP.)<br>* Page 6, lines 23-34; figure 4 * | 2-4 | |

-----

TECHNICAL FIELDS SEARCHED (Int. Cl.4)

G 01 L 5
G 01 L 1
G 01 M 19
H 01 R 43
H 05 K 13
G 01 D 5

The present search report has been drawn up for all claims

| Place of search | Date of completion of the search | Examiner |
|---|---|---|
| THE HAGUE | 10-04-1987 | VAN ASSCHE P.O. |